# EUROPEAN PATENT SPECIFICATION

(11) **EP 0 340 282 B1**
(45) Date of publication and mention of the grant of the patent: **17.07.1996**
(21) Application number: 88909902.4
(22) Date of filing: 11.10.1988
(51) Int. Cl.: H03K 17/16, H03K 17/687

(54) **TWO-MODE DRIVER CIRCUIT**
ZWEI MODEN TREIBERSCHALTUNG
CIRCUIT D'ATTAQUE BIMODAL

(30) Priority: 14.10.1987 US 108333
(43) Date of publication of application: 08.11.1989
(73) Proprietor: LSI LOGIC CORPORATION, Milpitas, CA 95035 (US)
(72) Inventor: WONG, Anthony, Y., Cupertino, CA 95014 (US); WONG, Daniel, San Jose, CA 95120 (US); CHAN, Steven, S., Cupertino, CA 94539 (US)
(74) Representative: Fieret, Johannes, Ir.
(86) International application number: US8803510
(87) International publication number: WO8903614

(56) References cited:
- EP-A- 0 125 733
- US-A- 4 473 762
- US-A- 4 532 439
- US-A- 4 567 378
- US-A- 4 622 482
- US-A- 4 725 747
- US-A- 5 478 600
- PATENTS ABSTRACTS OF JAPAN, vol. 11, no. 363 (E-560), 19 June 1987, & JP-A-62 136 914
- PATENTS ABSTRACTS OF JAPAN, vol. 9, no. 75 (E-306), 27 November 1984, & JP-A-59 208 926

## Description

### FIELD OF THE INVENTION

The present invention relates to driver circuits for generating output signals from an integrated circuit and, more specifically, a CMOS driver circuit capable of operating in two modes for integrated circuits.

### BACKGROUND OF THE INVENTION

Present day integrated circuits require an increasing number of line connections by which the integrated circuit communicates with the outside world. Physically an integrated circuit has a number of metallic pads around the periphery of the integrated circuit chips; the pads are connected to the rest of the integrated circuit. In use the integrated circuit chip is protected by a package which contains a number of metallic connections, typically pins, which electrically connect the integrated circuit to the outside world. The connections or pins are connected to the pads by metallic wires.

Many of these connections transmit the integrated circuit's internally generated signals to the outside world. These output connections require driver, or buffer, circuits in the integrated circuit. These driver circuits generate the required voltages and currents for the signals to be properly propagated to the outside world.

From document US-A-4 622 482 a driver circuit for connection between first and second reference voltage supplies is known, comprising first and second MOS inverters for driving first and second output transistors, respectively. Diode-connected MOS transistors are respectively applied between a supply terminal of the first inverter and the first reference voltage and between a supply terminal of the second MOS inverter and the second reference voltage.

In the process of manufacturing integrated circuits, there is typically a step in which the individual integrated circuits which have been manufactured on a single semiconductor substrate, called a wafer, are tested to determine whether each of the integrated circuits function properly or not before the integrated circuits are packaged. In this step, the wafer sort operation, each integrated circuit is tested by a number of probes which each contact the input/output pads of the integrated circuit. The other end of the probes are connected to a computer which, under the control of a test program, transmits test pattern signals to the integrated circuit and collects the responses for analysis. The proper signal responses determine that the integrated circuit is functional.

A problem arises, though, with the large number of output connections. Necessarily these driver circuits generate large amounts of surge currents as the driver circuits quickly switch back and forth from one logic state to another (logic 1 to logic 0 and vice versa). The problem during wafer sort is that the long conducting lines of the probes to the computer create electrical signal reflections and other noises. These erroneous signals are aggravated by the large surge currents created by the driver circuits that cause the testing computer to misread and not correctly analyze the integrated circuit under scrutiny.

The present invention is directed toward solving or substantially mitigating this problem by providing for a driver circuit which can operate in two modes. In the first mode, the driver circuit of the present invention operates normally, i.e., with large initial surge currents and quickly changing voltage levels to maintain the high speed operation of the integrated circuit. In the second mode, the driver circuit behaves as a weak driver so that during wafer sort the problems caused by large surge currents from a typical driver circuit are substantially reduced.

### SUMMARY OF THE INVENTION

The present invention provides for a driver circuit having a pair of output transistors connected between two reference voltage supplies. The two MOS output transistors are connected serially with the output terminal of the driver circuit between the two output transistors. The two MOS output transistors operate in a complementary fashion so that when one transistor is off, the other transistor is on so that the output terminal of the driver is in one logic state or the other. To control the output transistors, each gate terminal of the MOS output transistor is connected to the output terminal of an inverter circuit.

The drive capability of these output transistors is controlled by the magnitude of voltage on the output transistor gates. Each of these inverter circuits, connected between the two reference voltage supplies, has its input terminal connected to the input terminal of the driver circuit. Each of the inverter circuits has a pair of transistors connected between itself and one of the reference voltage supplies. One of the transistors has its gate terminal connected in a diode configuration and the other has its gate terminal connected to a control terminal.

When the signal on the control terminal turns the second transistor on, the inverter circuit to which the transistor pair is connected has a full current path between the reference voltage supplies. Hence the inverter operates at optimum drive capability. If the signal on the control terminal turns off the second transistor, the only current path for the inverter circuit between itself and the reference voltage supply is through the diode-connected transistor. This affects the output voltage of the inverter and the voltage on the gate terminal of the connected output transistor. The change in gate terminal voltage reduces the output current and drive capability of the output transistor.

The present invention also offers a driver circuit which can operate in the two modes as described previously and also go into a third state, a state of high impedance, besides a logic 1 and logic 0 state.

The present invention also provides for a driver circuit which is automatically slowed for slew rate control. This is achieved by connecting the output terminal of the driver circuit to the control terminal for an automatic feedback control of the switching speed of the driver circuit.

### BRIEF DESCRIPTION OF THE DRAWINGS

Fig. 1A shows a typical functional representation of a driver circuit with its input and output terminals;
Fig. 1B shows a functional representation of the present invention with an additional control terminal;
Fig. 2 shows the details of the driver circuit of the present invention;
Fig. 3A illustrates one of the CMOS inverter circuits used in driver circuits;
Fig. 3B illustrates another of the CMOS inverter circuits in Fig. 2;
Fig. 4 is a detailed diagram of another embodiment of the present invention, a driver circuit permitting the output terminal to go into a high impedance state;
Fig. 5A shows the details of an embodiment of the present invention with feedback for slew rate control for the driver circuit;
Fig. 5B shows the operation of the circuit illustrated in Fig. 5A.

It should be noted that same reference numerals are used in several of the drawings where the same element is intended.

### DETAILED DESCRIPTION OF THE INVENTION

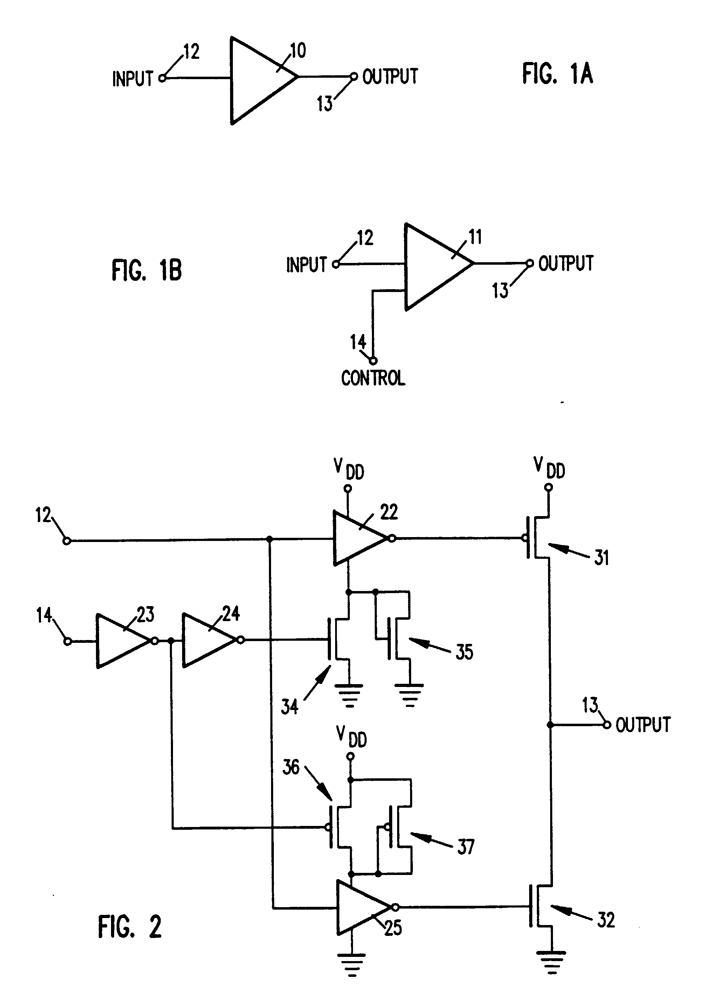

Fig. 1A illustrates functionally a driver circuit 10 having an input terminal 12 and an output terminal 13. The driver circuit 10 buffers the signal on the input terminal 12 to the output terminal 13.

Fig. 1B illustrates functionally the present invention, a driver circuit 11 which has the input and output terminals 12 and 13 described previously. Additionally, the present invention has a control terminal 14, through which the mode of operation of the driver circuit 11 is controlled. The driver circuit 11 can operate either in a high drive mode, or a low drive mode. As explained previously, the low drive mode is useful in reducing the amount of surge currents to prevent undesired anomalies when the circuit operating is a monitored circuit, such as the testing of the integrated circuit during the wafer sort operation.

Fig. 2 illustrates the details of the present invention. The driver circuit has two output transistors 31, 32 which are connected serially between two reference voltage supplies at V_{DD}, typically +5 volts, and ground, respectively. The transistor 31 is an MOS transistor with a P-channel, i.e., a PMOS transistor. One of the two source/drain regions of the transistor 31 is connected to the reference voltage supply at V_{DD}. The second source/drain region of the transistor 31 is connected to the output terminal 13 of the driver circuit.

The transistor 32 is, on the other hand, an MOS transistor with an N-channel, i.e., an NMOS transistor. One of its two source/drain regions is connected to the reference voltage supply at ground, while the other region is connected to the output terminal 13 and the second source/drain region of the transistor 31.

The gate terminals of the transistors 31, 32 are respectively connected to inverter circuits 22, 25. The input terminals of the lnverter circuits 22, 25 are connected to the input terminal 12. Operationally, a high signal on the input terminal 12 generates a low signal on the gate terminal of the PMOS transistor 31 due to the action of the inverter circuit 22. Similarly, the inverter 25 places a low signal on the gate terminal of the NMOS transistor 32. Thus, the PMOS transistor 31 is turned on and the NMOS transistor 32 is turned off so that the voltage at the output terminal 13 is high. On the other hand, a low signal on the input terminal 12 turns off the PMOS transistor 31 and turns on the NMOS transistor 32. The signal on the output terminal 13 is thus low.

Each of the inverter circuits 22, 25 has at least a pair of transistors connected in parallel between itself and one of the two reference voltage supplies. The pair of transistors is illustrative of the present invention, though more than two transistors may operate more effectively in the driver circuit, as explained below. In the case of the inverter circuit 22, the parallel transistor pair 34, 35 is between the inverter 22 and ground. For the inverter circuit 25 the transistor pair 36, 37 is between the inverter 25 and the reference voltage supply at V_{DD}.

Each transistor pair has a transistor 34 (or 36) which has its gate terminal coupled to the control terminal 14 and a transistor 35 (or 37) which is in a diode-connected configuration. The gate terminal of the PMOS transistor 36 is connected to the control terminal 14 through an inverter 23; the gate terminal of the NMOS transistor 34 is connected to the control terminal 14 through the inverter 23 and a second inverter 24. The inverters 23, 24 invert or maintain the logic level of the control signal on the control terminal 14. When the signal on the control terminal 14 is high, the NMOS transistor 34 is turned on; similarly, the PMOS transistor 36 is also turned on through the operation of the inverter 23. This permits the current through the inverter circuits 22, 25 to flow unimpeded between the output terminal of the inverter 22 or 25 and the V_{DD} or ground reference voltage supplies. The inverter 22 is effectively coupled to ground and the inverter 25 is likewise effectively coupled to V_{DD}. The output voltage of both inverters 22, 25 can swing fully between ground and V_{DD}, depending upon the signal level at input terminal 12.

However, when the signal on the control terminal 14 is low, the transistors 34, 36 are turned off and the current through the inverter circuits 22, 25 are forced through the diode-connected transistors 35, 37. The transistors 35, 37 are much smaller than the transistors 34, 36. Specifically, the channel widths of the transistors 35, 37 are much smaller than the channel widths of the transistors 34, 36. As a consequence, the output voltage of the inverters 22, 25 are restricted. The output voltage of the inverter 22 can only fall to a voltage approximately one diode voltage, V_{T}, above ground. Similarly, the output voltage of the inverter circuit 25 can only rise to one V_{T} below V_{DD}. V_{T} depends upon the specific parameters of the diode-connected transistor and typically varies from 1.0 - 1.5 volts. Also, the currents through the diode-connected transistors 35, 37 are reduced.

With the swing of the output voltages of the inverters 22, 25 reduced as explained above, the voltages of the gate terminals of the output transistors 31, 32 are also reduced. With less voltage on the gate terminals to turn on the output transistors 31, 32, the amount of output current through the output terminal 13 is lowered and the drive capability of the driver circuit is reduced.

On an integrated circuit the driver circuits shown in Fig. 2 may have their control terminal 14 connected to a single input pad. In this manner, a testing probe on that pad can place a low signal to all of the control terminals 14 of the driver circuits to place these driver circuits in a low drive mode. This permits testing of the integrated circuit to be accomplished more easily, as discussed previously.

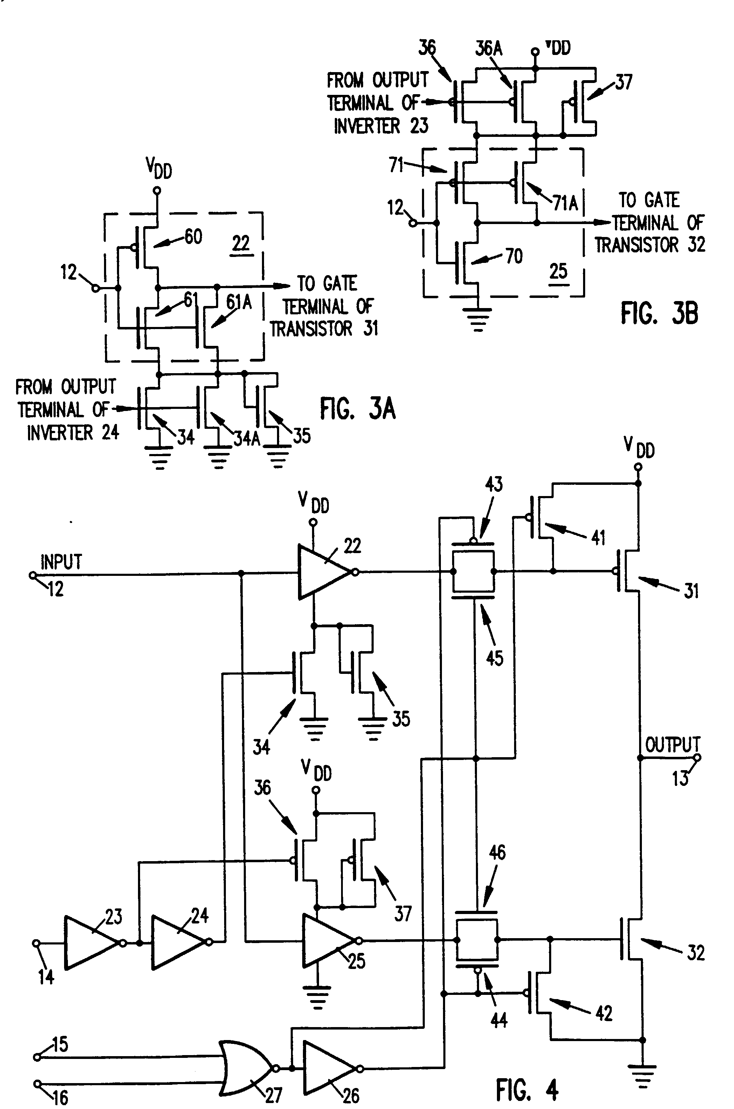

Figs. 3A and 3B, respectively, illustrate in detail the inverters 22, 25 with their transistor pairs 34, 35 and 36, 37. Fig. 3A shows the CMOS inverter 22, enclosed by a dotted line having a typical transistor pair, a PMOS transistor 60 and an NMOS transistor 61. Both transistors 60, 61 have their gate terminals connected to the input terminal 12. The output terminal of the inverter is connected to the drain region of the PMOS transistor 60 and the drain region of the NMOS transistor 61. This output terminal is connected to the gate terminal of the output transistor 31. Since the inverter 22 must be able to turn on the PMOS transistor 31, the inverter 22 has an additional NMOS transistor 61A connected in parallel to the NMOS transistor 61. This parallel combination of transistors 61, 61A optimizes the delay characteristics through the inverter 22. When the NMOS transistors 61, 61A are turned on, a larger amount of current can be pulled through the output terminal of the inverter 22 toward ground for faster switching. The parallel combination also insures that when the output terminal of the inverter 22 is to be pulled low toward ground, the voltage drop between the inverter output terminal and the ground reference supply is as small as possible.

Likewise, besides the transistor pair 34, 35, the transistor 34 has a second transistor 34A. This parallel-connected transistor 34A operates in the same manner as the transistor 61A in the inverter 22. That is, the parallel combination of the transistors 34, 34A optimizes the delay characteristics of the inverter 22. When the transistors 34, 34A are turned on, a larger amount of current may be pulled from the inverter 22 to ground than with the single transistor 34. The transistor 34A also cooperates with the transistor 34 to provide the smallest possible voltage drop between the inverter 22 and the ground reference voltage. Thus, the transistor 34A optimizes the operation and function of the transistor 34.

Fig. 3B details the inverter 25 and a variation on the transistor pair 36, 37 as described previously. The inverter 25 enclosed by a dotted line has the typical complementary transistor pair, an NMOS transistor 70, and PMOS transistor 71. The gate terminals of the transistors 70, 71 are connected to the input terminal 12. The drain regions of the NMOS transistor 70 and PMOS transistor 71 are connected to the output terminal of the inverter 23, which is connected to the gate terminal of the output transistor 32. To insure that the delay through the inverter 25 is optimized, the inverter 25 has a second PMOS transistor 71A connected in parallel to the transistor 71. The parallel transistor 71A helps supply a larger amount of current from the V_{DD} reference voltage supply to the output terminal of the inverter 25 when the transistors 71, 71A are switched on. The transistor 71A also insures that the output terminal of the inverter 25 is as close as possible to the V_{DD} reference voltage.

Furthermore, the transistor pair 36, 37 described above has a third transistor 36A which is connected in parallel to the PMOS transistor 36. The extra transistor 36A insures that the switching delay through the inverter 25 is optimized in the same manner as described for the transistor 71A.

Fig. 4 shows another embodiment of the present invention which permits the driver circuit to operate in the high and low drive modes as explained previously. The circuit in Fig. 4 also permits the output terminal 13 to go into a third state, a high impedance state, besides the logic high and logic low states. The circuit in Fig. 4 has parallel switching transistors 43, 45 between the gate terminal of the PMOS output transistor 31 and the output terminal of the inverter circuit 22. The gate terminal of the output transistor 31 is also connected to a PMOS clamping transistor 41, which has one of its source/drain regions connected to the transistor 31 gate electrode and the other source/drain region connected to the reference voltage supply at V_{DD}. The gate electrode of the clamping transistor 41 is connected to an output terminal of a NOR gate 27 with two input terminals 15, 16.

In a similar fashion there are switching transistors 44, 46 connected in parallel between the gate electrode of the NMOS output transistor 32 and the output terminal of the inverter circuit 25. The gate terminal of the output transistor 32 is also connected to an NMOS clamping transistor 42 having one of its source/drain regions connected to the transistor 32 gate electrode and the other source/drain region to ground. The gate electrode of the clamping transistor 42 is connected to the output terminal of the NOR gate 27 through an inverter circuit 26.

When the signal at the output terminal of the NOR gate 27 is low, the NMOS switching transistors 45, 46 are turned off. The PMOS switching transistors 43, 44 are also turned off through the operation of the inverter 26. With the NMOS transistors 45, 46 and the PMOS transistors 43, 44 off, the gate terminals of the output transistors 31, 32 are respectively isolated from the output terminals of the inverter circuits 22, 25. Furthermore, the low signal at the output terminal of the NOR gate 27 turns on the clamping transistor 41. The gate terminal of the PMOS output transistor 31 is effectively clamped to a high voltage near V_{DD} and the transistor 31 is turned off. The low signal is also inverted to a high signal by the inverter 26 to turn on the clamping transistor 42. Thus, gate terminal of the NMOS output transistor 32 is clamped to the low voltage near ground to turn the transistor 32 effectively off. The output terminal 13 is now cut off; it is in a high impedance state.

On the other hand, a high signal at the output terminal of the NOR gate 27 turns on the NMOS switching transistors 45, 46 and the PMOS switching transistors 43, 44 are also turned on through the action of the inverter 26. The two clamping transistors 41, 42 are turned off at the same time. The gate terminal of the PMOS output transistor 31 is thus connected to the output terminal of the inverter circuit 22 and the gate terminal of the NMOS output transistor 32 is connected to the output terminal of the inverter circuit 25. The driver circuit now operates as described previously.

The NOR gate 27 has two control terminals 15, 16 to effect the high impedance state of the driver circuit. One of the control terminals, say terminal 15, may be used to control the impedance state of each driver circuit individually, while the other terminal 16 can be connected to an input pad on the integrated circuit. This input pad is connected to similar control terminals 16 of other driver circuits on the integrated circuit. In the wafer sort operation when the probe to that input pad is high, all the driver circuits connected to the pad go into a high impedance state. This operation is useful for testing the integrated circuit also, specifically parametric DC testing of the integrated circuit.

In Fig. 5A the present invention provides for a driver circuit which has an output slew rate control. Instead of the transistor pair 34, 36 responding to the signal of the control terminal 14 as depicted in Fig. 2,
the gate terminals of the transistors 34, 36 are connected to the output terminal 13 through two inverters 28, 29. By this feedback connection the driver circuit is always slowed down. For example, as the signal on the input terminal 12 rises for a high signal, the signal on the gate terminal of the NMOS transistor 34 is kept low. The transistor 34 remains off. The current through the inverter circuit 22 is limited by the small channel width of the diode-connected transistor 35.

When the voltage on the output terminal 13 reaches the threshold voltage of the inverter 29, the voltage on the gate terminal of the transistor 34 through the inverter circuits 28, 29 are sufficient to turn on the transistor 34. The full current through the transistor 34 allows the inverter circuit 22 to operate in a full voltage swing between V_{DD} and ground. The output transistor 31 is quickly and fully turned on.

Similarly, when the driver circuit switches from a high logic level to a low logic level, the initial high voltage on the gate terminal of the PMOS transistor 36 relayed by two inverter circuits 28, 29 keeps that transistor 36 off. By the low current flow through the diode-connected transistor 37, the inverter 25 slowly switches to turn on the NMOS output transistor 32. When the output terminal 13 reaches the threshold voltage of the inverter 29, the transistor 36 is turned on and the inverter 25 operates with a full voltage swing. The transistor 32 is quickly and fully turned on and the signal at the output terminal 13 is low.

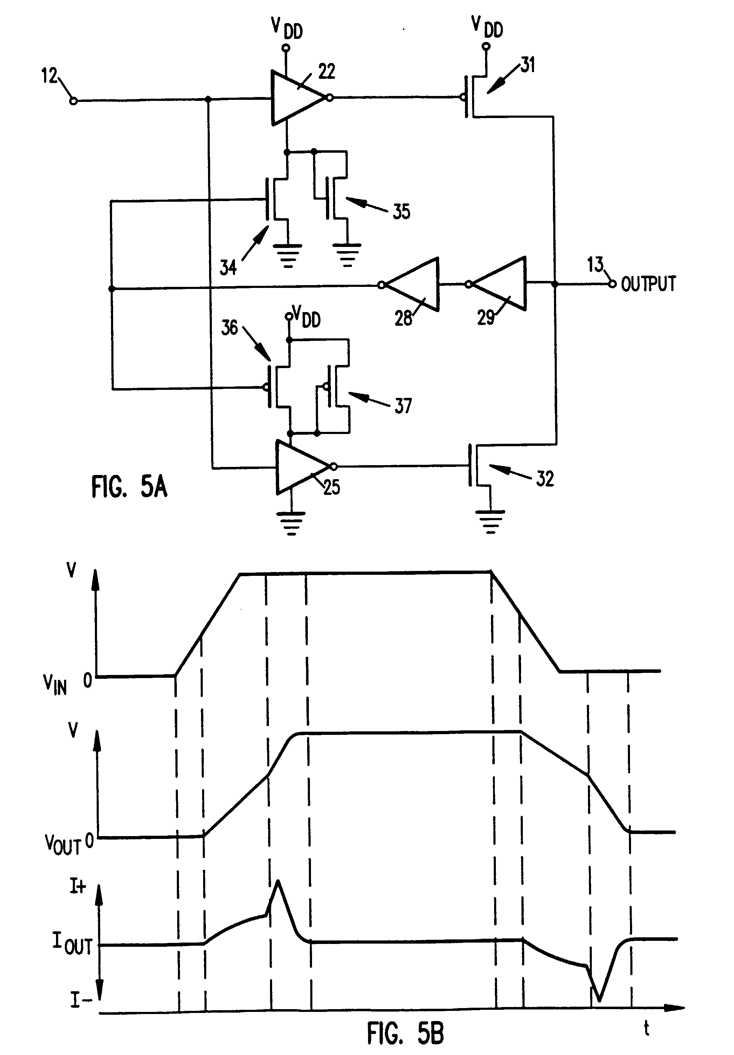

This operation is shown in Fig. 5B, which shows voltage and current signals over a horizontal time axis. V_{IN} is the input voltage signal at the input terminal 12; V_{OUT} is the output voltage signal at the output terminal 13. I_{OUT} is the current through the output terminal 13. As indicated by the Fig. 5B, the current can flow from the terminal 13, I_{OUT} positive, and can flow into the terminal 13, I_{OUT} negative. From the V_{OUT} signal it can be seen how each rising and falling slope of the voltage has a "knee," indicative of the slow and then fast operation of the driver circuit.

This feedback connection slows down the switching speed of the driver circuit somewhat. This driver circuit with reduced speed is useful in preventing high surge currents through the output transistors 31, 32 caused by a driver circuit operating at full speed. The reduction in surge currents avoids undesirable noise in the circuits. However, the feedback implementation of the present invention does not reduce the drive capability of the driver circuit since each of the output transistors 31, 32 are appropriately turned fully on after the delay in switching.

## Claims

1. A driver circuit having an input terminal (12), an output terminal (13), and first and second power terminals for connection to first and second reference voltage supplies respectively,
said driver circuit including:
a first MOS inverter (22), said first MOS inverter (22) having an input terminal and an output terminal; and
first (31) and second (32) MOS output transistors each MOS output transistor (31, 32) having a source region, a drain region and a gate;
first (34) and second (35) MOS transistors connected in parallel between one of said first and second power terminals and one of said first and second reference voltage supplies, said first (34) and second (35) MOS transistors each having a respective predetermined channel width, a drain region, a source region, and a gate, said first MOS transistor (34) having its gate connected to a third terminal (14) of said driver circuit and said second MOS transistor (35) having its gate connected to either its source or drain region such that said second MOS transistor (35) is configured for diode operation, said predetermined channel width of said second MOS transistor (35) being smaller than said predetermined channel width of said first MOS transistor (34);
a second MOS inverter (25), said second MOS inverter (25) having an input terminal and an output terminal; and
third (36) and fourth (37) MOS transistors connected in parallel between one of said first and second power terminals and one of said first and second reference voltage supplies, said third (36) and fourth (37) MOS transistors each having a respective predetermined channel width, a drain region, a source region, and a gate, said third MOS transistor (36) having its gate connected to said third terminal (14) and said fourth MOS transistor (37) having its gate connected to either its source or drain region such that said fourth MOS transistor (37) is configured for diode operation, said predetermined channel width of said fourth MOS transistor (37) being smaller than said predetermined channel width of said third MOS transistor (36);
said input terminals of said first (22) and second (25) MOS inverters being connected to said driver circuit input terminal (12), said output terminal of said first MOS inverter (22) being connected to said gate of said first MOS output transistor (31), said output terminal of said second MOS inverter (25) being connected to said gate of said second MOS output transistor (32);
whereby said driver circuit operation is slowed when a signal on said third terminal (14) turns off said first (34) and third (36) MOS transistors.

2. A driver circuit as in claim 1 wherein said first MOS inverter (22) is a CMOS inverter circuit.

3. A driver circuit as in claim 2 wherein said first reference voltage supply is at a higher voltage than said second reference voltage supply and said first (34) and second (35) MOS transistors are connected between said first reference voltage supply and said second power terminal.

4. A driver circuit as in claim 3 wherein said first (34) and second (35) MOS transistors are PMOS transistors.

5. A driver circuit as in claim 2 wherein said first reference voltage supply is at a higher voltage than said second reference voltage supply and said first (34) and second (35) MOS transistors are connected between said second reference voltage supply and said second power terminal.

6. A driver circuit as in claim 5 wherein said first (34) and second (35) MOS transistors are NMOS transistors.

7. A driver circuit as in claim 1 further comprising a fifth MOS transistor (34A) connected in parallel to said first MOS transistor (34).

8. A driver circuit as in claim 1 wherein one of either said source or drain regions of said first MOS output transistor (31) is connected to said first power terminal, the other one of said source or drain regions of said first MOS output transistor (31) being connected to said driver circuit output terminal (13) and to one of either said source or drain regions of said second MOS output transistor (32), the other one of said source or drain regions of said second MOS output transistor (32) being connected to said second power terminal.

9. A plurality of driver circuits as in claim 8 on an integrated circuit, said third terminals (14) of said driver circuits connected to an input pad whereby operations of all of said driver circuits are slowed by a signal on said input pad.

10. A driver circuit as in claim 8 wherein said first reference voltage supply is at a higher voltage than said second reference voltage supply;
said first MOS inverter (22) having its first (34) and second (35) MOS transistors connected in parallel between said first reference voltage supply and said first power terminal, said channel regions of said first (34) and second (35) MOS transistors being of a first polarity type; and
said second MOS inverter (25) having its third (36) and fourth (37) MOS transistors connected in parallel between said second reference voltage supply and said power terminal, said channel regions of said third (36) and fourth (37) MOS transistors being of a second polarity type.

11. The driver circuit as in claim 8 further comprising a fifth MOS transistor (36A) connected in parallel with said third MOS transistor (36).

12. The driver circuit as in claim 8 further comprising a fifth MOS transistor (34A) connected in parallel with said first MOS transistor (34), and;
a sixth MOS transistor (36A) connected in parallel with said third MOS transistor (36).

13. A driver circuit as in claim 8 wherein said first (34) and second (35) MOS transistors of said first MOS inverter (22) are NMOS transistors and said third (36) and fourth (37) MOS transistors of said second MOS inverter (25) are PMOS transistors.

14. A driver circuit as in claim 8 wherein said third terminal (14) is connected to said output terminal (13);
whereby said driver circuit is partially slowed by feedback action from said output terminal (13) to said first MOS transistor (34).

15. A driver circuit as in claim 8 further comprising:
a fourth input terminal;
a first switching means having a control terminal coupled to said fourth input terminal, said first switching means being connected between each of said output terminals of said MOS inverters (22, 25) and said gate of said MOS output transistors (31, 32) respectively for decoupling said output terminals of said MOS inverters (22, 25) from said gate upon application of a signal to said first switching means control terminal;
a second switching means having a control terminal, for connecting each of said gates of said MOS output transistors (31, 32) to said one of said reference voltage supplies, respectively, upon application of a signal to said second switching means control terminal, said second switching means control terminal being connected to said fourth input terminal;
whereby said driver circuit is placed into a high impedance state upon receiving a signal on said fourth input terminal.

16. An integrated circuit having at least one input pad and a plurality of driver circuits as in claim 15, each fourth input terminal of said driver circuits being connected to said input pads;
whereby a signal on said input terminal places all of said driver circuits into a high impedance state.

17. The driver circuit as in claim 15 wherein said first switching means comprises a pair of MOS transistors (43, 45) of opposing polarity, each MOS transistor (43, 45) having a source region, and a drain region, one of either said source or drain regions being connected to said output terminal of said MOS inverter (22) and the other of said source or drain regions being connected to said gate of said MOS output transistor (31), and a gate connected to said fourth input terminal.

18. The driver circuit as in claim 15 wherein said second switching means comprises a MOS transistor (41) having a source region and a drain region, one of either said source or drain regions being connected to said reference voltage supply and the other of said source or drain regions being connected to said gate of said MOS output transistor (31), and a gate connected to said fourth input terminal.

19. The driver circuit as in claim 15 further comprising a logic gate (27) having at least two input terminals (15, 16) and an output terminal connected to said fourth input terminal.

20. An integrated circuit having at least one input pad and a plurality of driver circuits as in claim 17 wherein one of said two input terminals is connected to said input pad;
whereby a signal on said input pad places all of said driver circuits into a high impedance state.

## Patentansprüche

1. Treiberschaltung mit einem Eingangsanschluß (12), einem Ausgangsanschluß (13) und ersten und zweiten Leistungsanschlüssen für die Verbindung mit ersten beziehungsweise zweiten Referenzspannungsversorgungen, wobei die Treiberschaltung folgendes umfaßt:
einen ersten MOS-Inverter (22), der einen Eingangs- und einen Ausgangsanschluß aufweist; und
erste (31) und zweite (32) MOS-Ausgangstransistoren, wobei jeder MOS-Ausgangstransistor (31, 32) ein Source-Gebiet, ein Drain-Gebiet und ein Gate aufweist;
erste (34) und zweite (35) MOS-Transistoren, die parallel zwischen einem der ersten und zweiten Leistungsanschlüsse und einem der ersten und zweiten Referenzspannungsversorgungen geschaltet sind, wobei die ersten (34) und zweiten (35) MOS-Transistoren jeweils vorbestimmte Kanalbreiten, ein Drain-Gebiet, ein Source-Gebiet und ein Gate aufweisen, wobei das Gate des ersten MOS-Transistors (34) mit einem dritten Anschluß (14) der Treiberschaltung verbunden ist und das Gate des zweiten MOS-Transistors (35) entweder mit seinem Source-Gebiet oder seinem Drain-Gebiet verbunden ist, so daß der zweite MOS-Transistor (35) für einen Diodenbetrieb ausgelegt ist, wobei die vorbestimmte Kanalbreite des zweiten MOS-Transistors (35) kleiner ist als die vorbestimmte Kanalbreite des ersten MOS-Transistors (34);
einen zweiten MOS-Inverter (25) mit einem Eingangs- und einem Ausgangsanschluß; und
dritte (36) und vierte (37) MOS-Transistoren, die parallel zwischen einem der ersten und zweiten Leistungsanschlüsse und einem der ersten und zweiten Referenzspannungsversorgungen geschaltet sind, wobei die dritten (36) und vierten (37) MOS-Transistoren jeder eine vorbestimmte Kanalbreite, ein Drain-Gebiet, ein Source-Gebiet und ein Gate aufweisen, wobei das Gate des dritten MOS-Transistors (36) mit dem dritten Anschluß (14) und das Gate des vierten MOS-Transistors (37) entweder mit dessen Source-Gebiet oder dessen Drain-Gebiet verbunden ist, so daß der vierte MOS-Transistor (37) für einen Diodenbetrieb ausgelegt ist, wobei die vorbestimmte Kanalbreite des vierten MOS-Transistors (37) kleiner ist als die vorbestimmte Kanalbreite des dritten MOS-Transistors (36);
wobei die Eingangsanschlüsse des ersten (22) und zweiten (25) MOS-Inverters mit dem Treiberschaltungseingangsanschluß (12) verbunden sind, der Ausgangsanschluß des ersten MOS-Inverters (22) mit dem Gate des ersten MOS-Ausgangstransistors (31) verbunden ist, der Ausgangsanschluß des zweiten MOS-Inverters (25) mit dem Gate des zweiten MOS-Ausgangstransistors (32) verbunden ist;
wobei der Treiberschaltungsbetrieb verlangsamt wird, wenn ein Signal am dritten Anschluß (14) die ersten (34) und dritten (36) MOS-Transistoren abschaltet.

2. Treiberschaltung nach Anspruch 1, wobei der erste MOS-Inverter (22) eine CMOS-Inverterschaltung ist.

3. Treiberschaltung nach Anspruch 2, wobei sich die erste Referenzspannungsversorgung auf einer höheren Spannung befindet als die zweite Referenzspannungsversorgung und die ersten (34) und zweiten (35) MOS-Transistoren zwischen der ersten Referenzspannungsversorgung und dem zweiten Leistungsanschluß geschaltet sind.

4. Treiberschaltung nach Anspruch 3, wobei die ersten (34) und zweiten (35) MOS-Transistoren PMOS-Transistoren sind.

5. Treiberschaltung nach Anspruch 2, wobei sich die erste Referenzspannungsversorgung auf einer höheren Spannung befindet als die zweite Referenzspannungsversorgung und die ersten (34) und zweiten (35) MOS-Transistoren zwischen der zweiten Referenzspannungsversorgung und dem zweiten Leistungsanschluß geschaltet sind.

6. Treiberschaltung nach Anspruch 5, wobei die ersten (34) und zweiten (35) MOS-Transistoren NMOS-Transistoren sind.

7. Treiberschaltung nach Anspruch 1, weiterhin einen fünften MOS-Transistor (34A) enthaltend, der parallel zum ersten MOS-Transistor (34) geschaltet ist.

8. Treiberschaltung nach Anspruch 1, wobei entweder das Source-Gebiet oder das Drain-Gebiet des ersten MOS-Ausgangstransistors (31) mit dem ersten Leistungsanschluß verbunden ist, das andere der Source- oder Drain-Gebiete des ersten MOS-Ausgangstransistors (31) mit dem Treiberschaltungsausgangsanschluß (13) und mit dem Source-Gebiet oder dem Drain-Gebiet des zweiten MOS-Ausgangstransistors (32) verbunden ist, wobei das andere der Source- oder Drain-Gebiete des zweiten MOS-Ausgangstransistors (32) mit dem zweiten Leistungsanschluß verbunden ist.

9. Eine Vielzahl von auf einer integrierten Schaltung angebrachten Treiberschaltungen wie in Anspruch 8, wobei die dritten Anschlüsse (14) der Treiberschaltungen mit einer Eingangsanschlußfläche verbunden sind, wobei der Betrieb aller dieser Treiberschaltungen durch ein Signal auf dieser Eingangsanschlußfläche verlangsamt wird.

10. Treiberschaltung nach Anspruch 8, wobei sich die erste Referenzspannungsversorgung auf einer höheren Spannung befindet als die zweite Referenzspannungsversorgung;
wobei die ersten (34) und zweiten (35) MOS-Transistoren des ersten MOS-Inverters (22) parallel zwischen der ersten Referenzspannungsversorgung und dem ersten Leistungsanschluß geschaltet sind; die Kanalgebiete der ersten (34) und zweiten (35) MOS-Transistoren von einem ersten Polaritätstyp sind; und
wobei die dritten (36) und vierten (37) MOS-Transistoren des zweiten MOS-Inverters (25) parallel zwischen der zweiten Referenzspannungsversorgung und dem Leistungsanschluß geschaltet sind; die Kanalgebiete der dritten (36) und vierten (37) MOS-Transistoren von einem zweiten Polaritätstyp sind.

11. Treiberschaltung nach Anspruch 8, weiterhin enthaltend einen fünften MOS-Transistor (36A), der parallel zum dritten MOS-Transistor (36) geschaltet ist.

12. Treiberschaltung nach Anspruch 8, weiterhin enthaltend einen fünften MOS-Transistor (34A), der parallel zum ersten MOS-Transistor (34) geschaltet ist; und
einen sechsten MOS-Transistor (36A), der parallel zum dritten MOS-Transistor (36) geschaltet ist.

13. Treiberschaltung nach Anspruch 8, wobei die ersten (34) und zweiten (35) MOS-Transistoren des ersten MOS-Inverters (22) NMOS-Transistoren und die dritten (36) und vierten (37) MOS-Transistoren des zweiten MOS-Inverters (25) PMOS-Transistoren sind.

14. Treiberschaltung nach Anspruch 8, wobei der dritte Anschluß (14) mit dem Ausgangsanschluß (13) verbunden ist;
wobei die Treiberschaltung teilweise durch einen Feedbackvorgang vom Ausgangsanschluß (13) zum ersten MOS-Transistor (34) verlangsamt wird.

15. Treiberschaltung nach Anspruch 8, weiterhin enthaltend:
einen vierten Eingangsanschluß;
eine erste Schaltvorrichtung mit einem Steueranschluß, die mit dem vierten Eingangsanschluß verbunden ist, wobei die erste Schaltvorrichtung jeweils zwischen jeden der Ausgangsanschlüsse der MOS-Inverter (22, 25) und dem Gate des MOS-Ausgangstransistors (31, 32) geschaltet ist, für das Abtrennen der Ausgangsanschlüsse des MOS-Inverters (22, 25) vom Gate nachdem ein Signal an den ersten Schaltvorrichtungssteueranschluß gelegt wurde;
eine zweite Schaltvorrichtung mit einem Steueranschluß zur Verbindung jedes der Gates der MOS-Ausgangstransistoren (31, 32) mit jeweils einer der Referenzspannungsversorgungen, nachdem ein Signal an den zweiten Schaltvorrichtungssteueranschluß gelegt wurde, wobei der zweite Schaltvorrichtungssteueranschluß mit dem vierten Eingangsanschluß verbunden ist;
wobei die Treiberschaltung in einen Zustand hoher Impedanz versetzt wird, nachdem ein Signal auf dem vierten Eingangsanschluß empfangen wurde.

16. Integrierte Schaltung mit mindestens einer Eingangsanschlußfläche und einer Vielzahl von Treibeschaltungen wie in Anspruch 15, wobei jeder vierte Eingangsanschluß der Treiberschaltungen mit den Eingangsanschlußflächen verbunden ist;
wobei ein Signal an diesem Eingangsanschluß alle diese Treiberschaltungen in einen Zustand hoher Impedanz versetzt.

17. Treiberschaltung nach Anspruch 15, wobei die erste Schaltvorrichtung ein Paar MOS-Transistoren (43, 45) entgegengesetzter Polarität umfaßt, wobei jeder MOS-Transistor (43, 45) ein Source-Gebiet und ein Drain-Gebiet aufweist, wobei entweder das Source-Gebiet oder das Drain-Gebiet mit dem Ausgangsanschluß des MOS-Inverters (22) verbunden ist und das andere der Source- und Drain-Gebiete mit dem Gate des MOS-Ausgangstransistors (31) verbunden ist, und ein Gate mit dem vierten Eingangsanschluß verbunden ist.

18. Treiberschaltung nach Anspruch 15, wobei die zweite Schaltvorrichtung einen MOS-Transistor (41) umfaßt, der ein Source-Gebiet und ein Drain-Gebiet aufweist, wobei eines der Source- oder Drain-Gebiete mit der Referenzspannungsversorgung und das andere der Source- oder Drain-Gebiete mit dem Gate des MOS-Ausgangstransistors (31) verbunden ist, und ein Gate mit dem vierten Eingangsanschluß verbunden ist.

19. Treiberschaltung nach Anspruch 15, weiterhin enthaltend ein logisches Gatter (27), das mindestens zwei Eingangsanschlüsse (15, 16) und einen Ausgangsanschluß, der mit dem vierten Eingangsanschluß verbunden ist, aufweist.

20. Integrierte Schaltung mit mindestens einer Eingangsanschlußfläche und einer Vielzahl von Treiberschaltungen, wie in Anspruch 17, wobei einer der zwei Eingangsanschlüsse mit der Eingangsanschlußfläche verbunden ist;
wobei ein Signal an dieser Eingangsanschlußfläche alle diese Treiberschaltungen in einen Zustand hoher Impedanz versetzt.

## Revendications

1. Amplificateur comportant une borne d'entrée (12), une borne de sortie (13), et des première et seconde bornes d'alimentation destinées à être connectées à des première et seconde sources de tension de référence, respectivement,
ledit amplificateur comportant :
un premier inverseur MOS (22), ledit premier inverseur MOS (22) ayant une borne d'entrée et une borne de sortie, et
des premier (31) et second (32) transistors de sortie MOS, chaque transistor de sortie MOS (31, 32) ayant une région de source, une région de drain et une grille,
des premier (34) et deuxième (35) transistors MOS, connectés en parallèle entre l'une desdites première et seconde bornes d'alimentation et l'une desdites première et seconde sources de tension de référence, lesdits premier (34) et deuxième (35) transistors MOS ayant chacun une largeur de canal prédéterminée, une région de drain, une région de source, et une grille respectives, ledit premier transistor MOS (34) ayant sa grille connectée à une troisième borne (14) dudit amplificateur et ledit deuxième transistor MOS (35) ayant sa grille connectée à sa région de source ou à sa région de drain de sorte que ledit deuxième transistor MOS (35) est configuré pour agir comme une diode, ladite largeur de canal prédéterminée dudit deuxième transistor MOS (35) étant inférieure à ladite largeur de canal prédéterminée dudit premier transistor MOS (34),
un second inverseur MOS (25), ledit second inverseur MOS (25) ayant une borne d'entrée et une borne de sortie et,
des troisième (36) et quatrième (37) transistors MOS connectés en parallèle entre l'une desdites première et seconde bornes d'alimentation et l'une desdites première et seconde sources de tension de référence, lesdits troisième (36) et quatrième (37) transistors MOS ayant chacun une largeur de canal prédéterminée, une région de drain, une région de source, et une grille respectives, ledit troisième transistor MOS (36) ayant sa grille connectée à ladite troisième borne (14) et ledit quatrième transistor MOS (37) ayant sa grille connectée à sa région de source ou à sa région de drain de sorte que ledit quatrième transistor MOS (37) est configuré pour agir comme une diode, ladite largeur de canal prédéterminée dudit quatrième transistor MOS (37) étant inférieure à ladite largeur de canal prédéterminée dudit troisième transistor MOS (36),
lesdites bornes d'entrée desdits premier (22) et second (25) inverseurs MOS étant connectées à ladite borne d'entrée (12) de l'amplificateur, ladite borne de sortie dudit premier inverseur MOS (22) étant connectée à ladite grille dudit premier transistor de sortie MOS (31), ladite borne de sortie dudit second inverseur MOS (25) étant connectée à ladite grille dudit second transistor de sortie MOS (32),
le fonctionnement dudit amplificateur étant ralenti lorsqu'un signal transmis sur ladite troisième borne (14) commute en mode bloqué lesdits premier (34) et troisième (36) transistors MOS.

2. Amplificateur selon la revendication 1, dans lequel ledit premier inverseur MOS (22) est un inverseur CMOS.

3. Amplificateur selon la revendication 2, dans lequel ladite première source de tension de référence est à une tension supérieure à celle de ladite seconde source de tension de référence et lesdits premier (34) et deuxième (35) transistors MOS sont connectés entre la première source de tension de référence et ladite seconde borne d'alimentation.

4. Amplificateur selon la revendication 3, dans lequel lesdits premier (34) et deuxième (35) transistors MOS sont des transistors PMOS.

5. Amplificateur selon la revendication 2, dans lequel ladite première source de tension de référence est à une tension supérieure à celle de ladite seconde source de tension de référence et lesdits premier (34) et deuxième (35) transistors MOS sont connectés entre ladite seconde source de tension de référence et ladite seconde borne d'alimentation.

6. Amplificateur selon la revendication 5, dans lequel lesdits premier (34) et deuxième (35) transistors MOS sont des transistors NMOS.

7. Amplificateur selon la revendication 1, comportant en outre un cinquième transistor MOS (34A) connecté en parallèle audit premier transistor MOS (34).

8. Amplificateur selon la revendication 1, dans lequel l'une desdites régions de source ou de drain dudit premier transistor de sortie MOS (31) est connectée à ladite première borne d'alimentation, l'autre desdites régions de source ou de drain dudit premier transistor de sortie MOS (31) étant connectée à ladite borne de sortie (13) de l'amplificateur et à l'une desdites régions de source ou de drain dudit second transistor de sortie MOS (32), l'autre desdites régions de source ou de drain dudit second transistor de sortie MOS (32) étant connectée à ladite seconde borne d'alimentation.

9. Ensemble d'amplificateurs selon la revendication 8 agencés sur un circuit intégré, lesdites troisièmes bornes (14) desdits amplificateurs étant connectées à une plage d'entrée, de sorte que le fonctionnement de tous lesdits amplificateurs soit ralenti par un signal appliqué sur ladite plage d'entrée.

10. Amplificateur selon la revendication 8, dans lequel ladite première source de tension de référence est à une tension supérieure à celle de ladite seconde source de tension de référence,
ledit premier inverseur MOS (22) ayant ses premier (34) et deuxième (35) transistors MOS connectés en parallèle entre ladite première source de tension de référence et ladite première borne d'alimentation, lesdites régions de canal desdits premier (34) et deuxième (35) transistors MOS possédant un premier type de polarité, et
ledit second inverseur MOS (25) ayant ses troisième (36) et quatrième (37) transistors MOS connectés en parallèle entre ladite seconde source de tension de référence et ladite borne d'alimentation, lesdites régions de canal desdits troisième (36) et quatrième (37) transistors MOS possédant un second type de polarité.

11. Amplificateur selon la revendication 8, comportant en outre un cinquième transistor MOS (36A) connecté en parallèle audit troisième transistor MOS (36).

12. Amplificateur selon la revendication 8, comportant en outre un cinquième transistor MOS (34A) connecté en parallèle audit premier transistor MOS (34), et
un sixième transistor MOS (36A) connecté en parallèle audit troisième transistor MOS (36).

13. Amplificateur selon la revendication 8, dans lequel lesdits premier (34) et deuxième (35) transistors MOS dudit premier inverseur MOS (22) sont des transistors NMOS, et lesdits troisième (36) et quatrième (37) transistors MOS dudit second inverseur MOS (25) sont des transistors PMOS.

14. Amplificateur selon la revendication 8, dans lequel ladite troisième borne (14) est connectée à ladite borne de sortie (13),
de sorte que ledit amplificateur est partiellement ralenti par l'action de rétroaction de ladite borne de sortie (13) sur ledit premier transistor MOS (34).

15. Amplificateur selon la revendication 8, comportant en outre :
une quatrième borne d'entrée,
des premiers moyens de commutation ayant une borne de commande couplée à ladite quatrième borne d'entrée, lesdits premiers moyens de commutation étant connectés entre chacune desdites bornes de sortie desdits inverseurs MOS (22, 25) et ladite grille desdits transistors de sortie MOS (31, 32), respectivement, pour découpler lesdites bornes de sortie desdits inverseurs MOS (22, 25) de ladite grille lors de l'application d'un signal sur ladite borne de commande des premiers moyens de commutation,
des seconds moyens de commutation ayant une borne de commande, pour connecter chacune desdites grilles desdits transistors de sortie MOS (31, 32) à l'une desdites sources de tension de référence, respectivement, lors de l'application d'un signal sur ladite borne de commande des seconds moyens de commutation, ladite borne de commande des seconds moyens de commutation étant connectée à ladite quatrième borne d'entrée,
ledit amplificateur étant placé dans un état de haute impédance lors de la réception d'un signal sur ladite quatrième borne d'entrée.

16. Circuit intégré comportant au moins une plage d'entrée et plusieurs amplificateurs selon la revendication 15, chaque quatrième borne d'entrée desdits amplificateurs étant connectée auxdites plages d'entrée,
un signal appliqué sur ladite borne d'entrée plaçant tous lesdits amplificateurs dans un état de haute impédance.

17. Amplificateur selon la revendication 15, dans lequel lesdits premiers moyens de commutation comportent une paire de transistors MOS (43, 45) de polarités opposées, chaque transistor MOS (43, 45) ayant une région de source, une région de drain, l'une desdites régions de source ou de drain étant connectée à ladite borne de sortie dudit inverseur MOS (22) et l'autre desdites régions de source ou de drain étant connectée à ladite grille dudit transistor de sortie MOS (31), et une grille étant connectée à ladite quatrième borne d'entrée.

18. Amplificateur selon la revendication 15, dans lequel lesdits seconds moyens de commutation comportent un transistor MOS (41) ayant une région de source et une région de drain, l'une desdites régions de source ou de drain étant connectée à ladite source de tension de référence et l'autre desdites régions de source ou de drain étant connectée à ladite grille dudit transistor de sortie MOS (31), et une grille étant connectée à ladite quatrième borne d'entrée.

19. Amplificateur selon la revendication 15, comportant en outre une porte logique (27) ayant au moins deux bornes d'entrée (15, 16) et une borne de sortie connectée à ladite quatrième borne d'entrée.

20. Circuit intégré comportant au moins une plage d'entrée et plusieurs amplificateurs selon la revendication 17, dans lequel l'une desdites deux bornes d'entrée est connectée à ladite plage d'entrée,
un signal appliqué sur ladite plage d'entrée plaçant tous lesdits amplificateurs dans un état de haute impédance.
